# EUROPEAN PATENT SPECIFICATION

(11) **EP 4 557 887 B1**
(45) Date of publication and mention of the grant of the patent: **09.12.2026**
(21) Application number: 23839270.8
(22) Date of filing: 26.04.2023
(51) Int. Cl.: H05B 3/48, H05B 3/28, H10P 72/00, H10P 72/76

(54) **SHEATH HEATER AND STAGE**
MANTELHEIZER UND BÜHNE
DISPOSITIF DE CHAUFFAGE À GAINE ET ÉTAGE

(30) Priority: 13.07.2022 JP 2022112544
(43) Date of publication of application: 21.05.2025
(73) Proprietor: NHK Spring Co., Ltd., Yokohama-shi, Kanagawa 236-0004 (JP)
(72) Inventor: AIKAWA, Naoya, Yokohama-shi, Kanagawa 236-0004 (JP); KIDA, Naoya, Yokohama-shi, Kanagawa 236-0004 (JP); FUTAKUCHIYA, Jun, Yokohama-shi, Kanagawa 236-0004 (JP); FUJINO, Daisuke, Yokohama-shi, Kanagawa 236-0004 (JP); TAKANASHI, Masaya, Yokohama-shi, Kanagawa 236-0004 (JP)
(74) Representative: dompatent
(86) International application number: PCT/JP2023/016491
(87) International publication number: WO 2024/014092

(56) References cited:
- JP-A- 2004 056 084
- JP-A- 2004 296 532
- JP-A- 2010 257 582
- JP-A- 2021 026 857
- JP-A- S4 811 634
- JP-B2- 4 913 839
- JP-Y1- S4 831 562
- JP-Y1- S41 773
- US-A1- 2021 235 550
- US-A1- 2022 151 031

## Description

### TECHNICAL FIELD

The present invention relates to a sheath heater and a stage including the sheath heater.

### BACKGROUND ART

Semiconductor devices are installed in almost all electronic devices and play an important role for the functions of the electronic devices. Semiconductor devices utilize semiconductor characteristics possessed by silicon, etc. Semiconductor devices are constructed by stacking a semiconductor film, an insulating film, and a conductive film on a substrate and patterning these films. These films are stacked by vapor deposition, sputtering, chemical vapor phase deposition (CVD), or substrate chemical reactions, and are patterned by a photolithography process. The photolithography process includes the formation of a resist on the films that are subjected to patterning, the exposure of the resist, the formation of a resist mask by development, the partial removal of these films by etching, and the removal of the resist mask.

The characteristics of the films described above depend largely on the conditions for forming the films or the conditions for patterning. One of the above conditions is a temperature of the substrate. In many cases, the temperature of the substrate is controlled by adjusting the temperature of a stage on which the substrate is placed. A sheath heater is one of the heaters that heat the stage in order to heat the substrate and uniformly suppress the temperature distribution in the substrate. For example, Patent Literature 1 discloses a stage equipped with multiple sheath heaters in which an electric heating wire (a heater wire) is arranged in a metal sheath. JP491839B2 discloses a sheath heater according to the preamble of claim 1.

### CITATION LIST

### PATENT LITERATURE

Patent Literature 1: Japanese laid-open patent publication No. 2009-91660
Patent Literature 2: Japanese laid-open patent publication No. 2021-26857

### SUMMARY OF INVENTION

### TECHNICAL PROBLEM

In a sheath heater, an insulating material is filled in a metal sheath to prevent a short circuit between the metal sheath and a heater wire (for example, see Patent Literature 2). Further, an end of the metal sheath is sealed with an epoxy adhesive to prevent moisture absorption and scattering of the insulating material filled in the metal sheath. When the sheath heater is used in a stage, it is preferable that the end of the metal sheath is stored in a shaft of the stage. However, the temperature inside the shaft may become high (for example, over 100 degrees). In that case, since the heat resistance temperature of the epoxy adhesive is low, the above-described configuration cannot be applied. Therefore, a sheath heater with improved heat resistance has been desired in order to widen the operating temperature range of the stage.

In view of the above problems, the present invention provides a sheath heater with improved heat resistance and a stage including said sheath heater that is used in a wide temperature range. The invention is set out in independent claims 1 and 11. Preferred embodiments are reflected in the dependent claims.

### SOLUTION TO PROBLEM

A sheath heater according to an embodiment of the present invention includes a metal sheath, a heater wire disposed in the metal sheath, an insulating material filled in the metal sheath so as to separate the metal sheath and the heater wire, a lead wire for supplying power to the heater wire, a crimp sleeve connecting the heater wire extending from an end of the metal sheath with the lead wire, a cylindrical member covering the end of the metal sheath, and a lid member engaging with the cylindrical member and including an opening into which the lead wire is inserted. The crimp sleeve is disposed in the cylindrical member. The end of the metal sheath includes a first insulating tube including a first through hole into which the heater wire is inserted and a sealing material filling a gap between the metal sheath and the first insulating tube. The sealing material includes a ceramic binder.

The first insulating tube may include two first through holes.

The sheath heater may further include a second insulating tube disposed in the cylindrical member and including a second through hole. The the crimp sleeve may be disposed in the second through hole.

The second insulating tube may include two second through holes.

The sheath heater may further include a locking member fixed to the lead wire. The locking member may not be joined to the lid member. The locking member may be fixed to the lead wire by clamping the lead wire.

The sheath heater may further include a third insulating tube disposed between the first insulating tube and the second insulating tube in the cylindrical member and including a third through hole into which the heater wire is inserted. An outer diameter of the the third insulating tube may be smaller than a hole diameter of the the second through hole.

A part of the third insulating tube may be inserted into the second through hole. The two third insulating tubes are disposed in the cylindrical member.

A stage according to an embodiment of the present invention includes a shaft and the above sheath heater. The end of the metal sheath is stored in the shaft.

### ADVANTAGEOUS EFFECTS OF INVENTION

A sheath heater according to an embodiment of the present invention has a structure in which a terminal portion can withstand high temperatures. Therefore, heat resistance of the sheath heater is improved. Further, a stage according to an embodiment of the present invention includes the sheath heater with improved heat resistance, so that the operating temperature range of the stage is widened.

### BRIEF DESCRIPTION OF DRAWINGS

FIG. 1 is a schematic plan view showing an external configuration of a heater of a sheath heater according to an embodiment of the present invention.
FIG. 2 is a schematic cross-sectional view showing an internal configuration of a sheath heater according to an embodiment of the present invention.
FIG. 3A is a schematic cross-sectional view showing a configuration of a sheath heater according to an embodiment of the present invention.
FIG. 3B is a schematic cross-sectional view showing a configuration of a sheath heater according to an embodiment of the present invention.
FIG. 3C is a schematic cross-sectional view showing a configuration of a sheath heater according to an embodiment of the present invention.
FIG. 4 is a schematic perspective view showing an external configuration of a stage according to an embodiment of the present invention.
FIG. 5 is a schematic top view showing an arrangement of a sheath heater included in a stage according to an embodiment of the present invention.
FIG. 6 is a schematic cross-sectional view showing an internal configuration of a stage according to an embodiment of the present invention.
FIG. 7 is a schematic cross-sectional view showing an internal configuration of a stage according to an embodiment of the present invention.
FIG. 8 is a schematic cross-sectional view showing an internal configuration of a stage according to an embodiment of the present invention.
FIG. 9 is a schematic top view showing an arrangement of sheath heaters included in a stage according to an embodiment of the present invention.
FIG. 10 is a schematic cross-sectional view showing a configuration of an etching apparatus according to an embodiment of the present invention.
FIG. 11 is a schematic cross-sectional view showing a configuration of a CVD apparatus according to an embodiment of the present invention.
FIG. 12 is a schematic cross-sectional view showing a configuration of a sputtering apparatus according to an embodiment of the present invention.
FIG. 13 is a schematic cross-sectional view showing a configuration of an evaporation apparatus according to an embodiment of the present invention.

### DESCRIPTION OF EMBODIMENTS

Hereinafter, embodiments of the invention disclosed in the present application are described with reference to the drawings. However, the present invention can be implemented in various forms without departing from the gist thereof and should not be construed as being limited to the description of the following exemplary embodiments.

For the sake of clarity of description, the drawings may be schematically represented with respect to widths, thicknesses, shapes, and the like of the respective portions compared with actual embodiments. However, they are merely an example and do not limit the interpretation of the present invention. In the present specification and the respective drawings, components having the same functions as those described with reference to the preceding drawings are denoted by the same reference numerals, and a duplicate description thereof may be omitted. Further, although the terms "upper" and "lower" are used in the explanation, the terms "upper" and "lower" respectively indicate the direction when the stage is in use (when a substrate is placed on it).

In the specification and the drawings, the same reference numerals are used when multiple components are identical or similar in general, and reference numerals with a lower or upper case letter of the alphabet are used when the multiple components are distinguished. Further, reference numerals with a hyphen and a natural number are used when multiple portions of one component are distinguished.

### <First Embodiment>

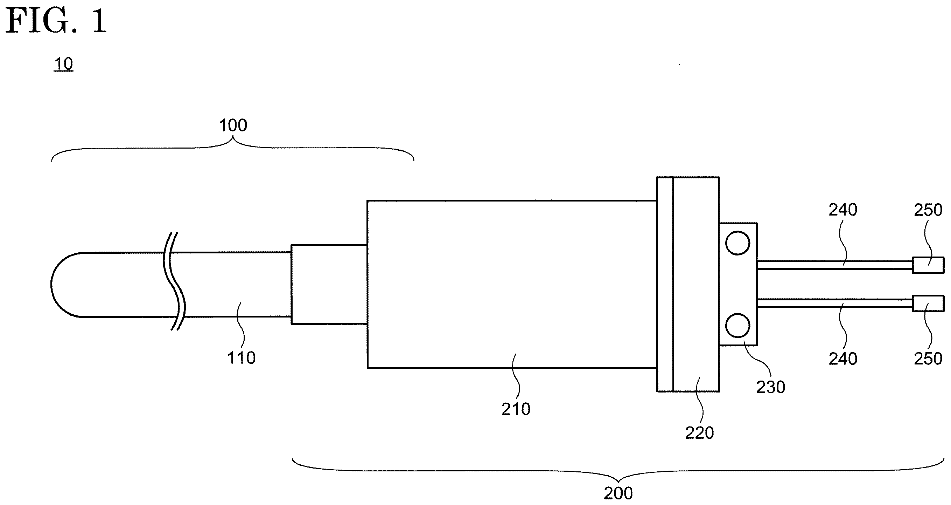

A sheath heater 10 according to an embodiment of the present invention is described with reference to FIGS. 1 to 3C.

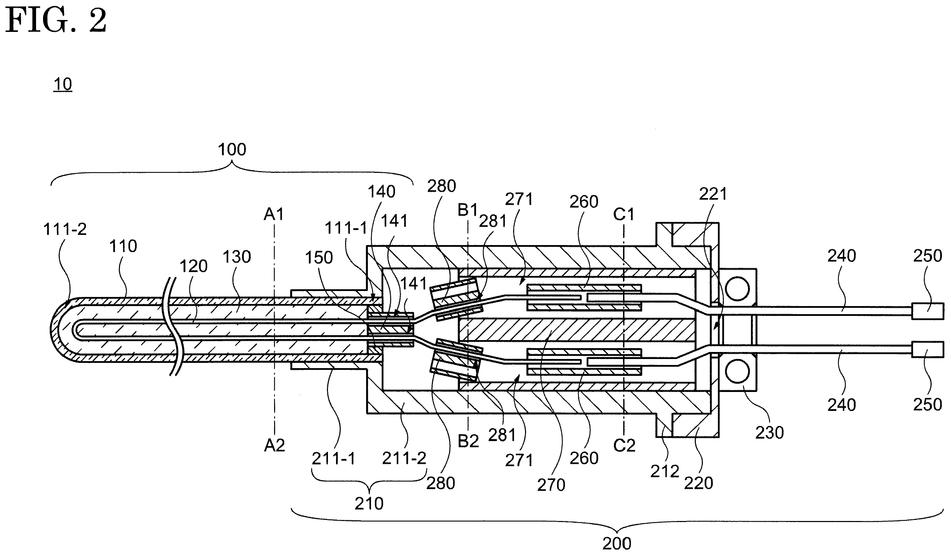

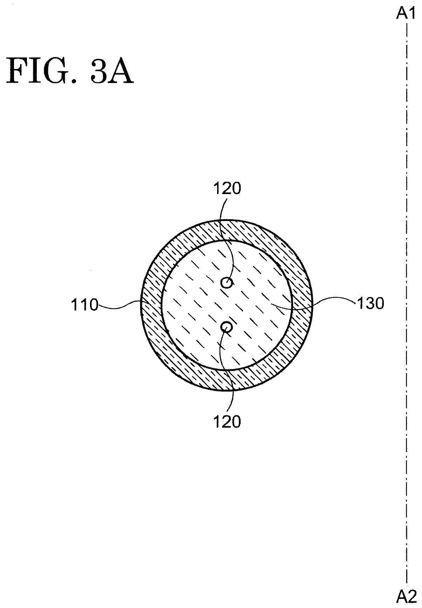

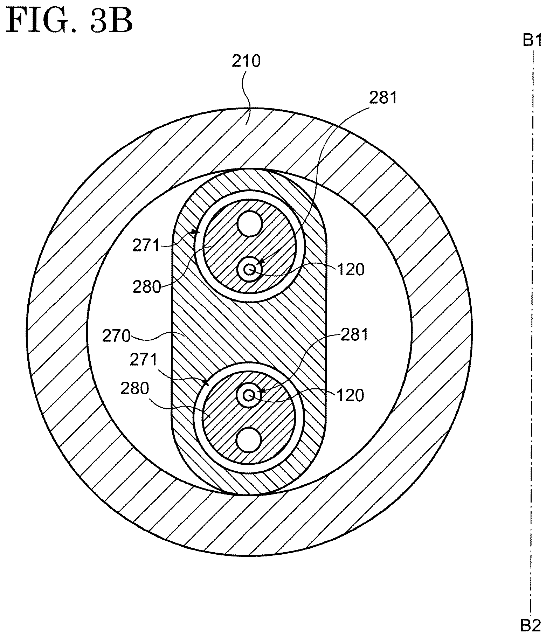

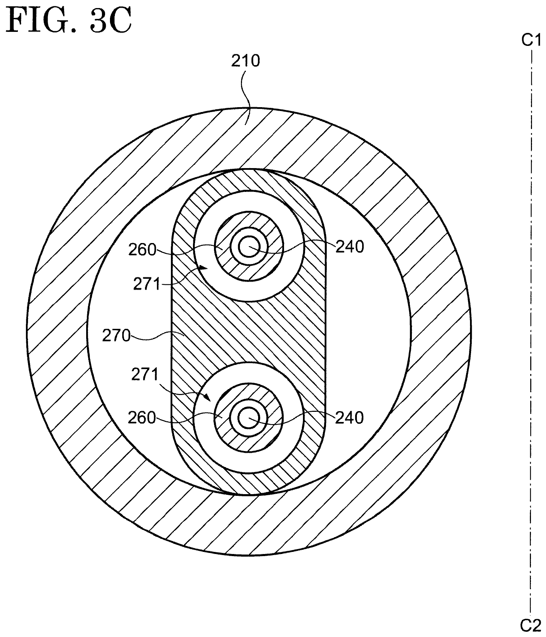

FIG. 1 is a schematic plan view showing an external configuration of the sheath heater 10 according to an embodiment of the present invention. FIG. 2 is a schematic cross-sectional view showing an internal configuration of the sheath heater 10 according to an embodiment of the present invention. Specifically, FIG. 2 is a cross-sectional view corresponding to the plan view of FIG. 1. FIGS. 3A to 3C are schematic cross-sectional views showing a configuration of the sheath heater 10 according to an embodiment of the present invention. Specifically, FIG. 3A is a cross-sectional view of the sheath heater 10 taken along line A1-A2 shown in FIG. 2, FIG. 3B is a cross-sectional view of the sheath heater 10 taken along line B1-B2 shown in FIG. 2, and FIG. 3C is a cross-sectional view of the sheath heater 10 taken along line C1-C2 shown in FIG. 2.

The sheath heater 10 includes a heater portion 100 and a terminal portion 200. The heater portion 100 includes a metal sheath 110, a heater wire 120, an insulating material 130, a first insulating tube 140, and a sealing material 150. The terminal portion 200 includes a cylindrical member 210, a lid member 220, a locking member 230, a lead wire 240, a connection terminal 250, a crimp sleeve 260, a second insulating tube 270, and a third insulating tube 280. In addition, some of the components of the heater portion 100 are inserted into the terminal portion 200, and may be described as the terminal portion 200 in the following description.

In the heater portion 100, the heater wire 120 is disposed in the metal sheath 110. The insulating material 130 is filled in the metal sheath 110 so as to separate the metal sheath 110 from the heater wire 120. In other words, the heater wire 120 is embedded in the insulating material 130 and is electrically insulated from the metal sheath 110.

A first end 111-1 of the metal sheath 110 is opened, and a second end 111-2 of the metal sheath 110 is closed. The first insulating tube 140 is disposed at the first end 111-1 of the metal sheath 110. The sealing material 150 is filled in the gap between the metal sheath 110 and the first insulating tube 140, and the first insulating tube 140 is fixed to the first end 111-1 of the metal sheath 110.

Although the cross-sectional shape of the first insulating tube 140 is circular, the cross-sectional shape of the first insulating tube 140 is not limited thereto. It is preferable that the outer diameter of the first insulating tube 140 is smaller than the inner diameter of the metal sheath 110, and a part of the first insulating tube 140 is inserted into the metal sheath 110. The first insulating tube 140 includes two first through holes 141. In the metal sheath 110, the heater wire 120 is folded, and both ends of the heater wire 120 extend outward from the first end 111-1 of the metal sheath 110. In other words, each of the two heater wires 120 corresponding to both ends is inserted into the first through hole 141 at the first end 111-1 of the metal sheath 110.

The metal sheath 110 has a small outer diameter and is flexible. Therefore, the heater portion 100 can be bent. Further, since the heater wire 120 is protected by the metal sheath 110 and the insulating material 130, the heater portion 100 has excellent impact resistance and corrosion resistance.

The thermal conductivity of the metal sheath 110 is preferably greater than or equal to 10 W/mK and less than or equal to 430 W/mK. For example, a metal such as aluminum, titanium, nickel, iron, chromium, niobium, copper, or molybdenum, or an alloy thereof can be used as the material of the metal sheath 110.

The heater wire 120 includes a heating wire and a non-heating wire. The heating wire generates heat when power is supplied to it. On the other hand, the non-heating wire has a higher thermal conductivity than the heating wire, and the generation of heat is suppressed. Therefore, when power is supplied to the heater wire 120, heat is generated mainly in the heating wire. The joint portion between the heating wire and the non-heating wire is located inside the metal sheath 110, and the non-heating wire of the heater wire 120 extends outward from the first end 111-1 of the metal sheath 110. For example, a metal such as nickel, chromium, iron, molybdenum, tungsten, or aluminum, or carbon, or an alloy thereof or oxide thereof can be used as the material of the heating wire. For example, a metal such as aluminum, copper, nickel, or iron, or an alloy thereof can be used as the material of the non-heating wire.

The insulating material 130 is filled in the metal sheath 110 in the form of a powder or fine particles. Alternatively, the insulating material 130 may be filled in the metal sheath 110 in the form of a sintered body, a pre-sintered body, or a compact of powder or fine particles. The thermal conductivity of the insulating material 130 is preferably greater than or equal to 10 W/mK and less than or equal to 300 W/mK. For example, magnesium oxide, aluminum oxide, silicon oxide, zirconium oxide, tantalum oxide, boron nitride, aluminum nitride, silicon nitride, zirconium nitride, titanium nitride, tantalum nitride, molybdenum nitride, niobium nitride, boron carbide, aluminum carbide, silicon carbide, zirconium carbide, titanium carbide, tantalum carbide, molybdenum carbide, or niobium carbide can be used as the material of the insulating material 130.

For example, magnesium oxide, aluminum oxide, aluminum nitride, silicon oxide, zirconium oxide, tantalum oxide, boron nitride, aluminum nitride, silicon nitride, zirconium nitride, titanium nitride, tantalum nitride, molybdenum nitride, niobium nitride, boron carbide, aluminum carbide, silicon carbide, zirconium carbide, titanium carbide, tantalum carbide, molybdenum carbide, or niobium carbide can be used as the material of the first insulating tube 140.

For example, a ceramic-based sealant containing a ceramic binder is used as the sealing material 150. The ceramic-based sealant has better heat resistance than an epoxy-based sealant. For example, magnesium oxide, aluminum oxide, aluminum nitride, silicon oxide, zirconium oxide, tantalum oxide, boron nitride, aluminum nitride, silicon nitride, zirconium nitride, titanium nitride, tantalum nitride, molybdenum nitride, niobium nitride, boron carbide, aluminum carbide, silicon carbide, zirconium carbide, titanium carbide, tantalum carbide, molybdenum carbide, or niobium carbide can be used as the material of the ceramic binder.

In the terminal portion 200, the cylindrical member 210 includes a first cylindrical body 211-1 and a second cylindrical body 211-2, and has a structure in which the first cylindrical body 211-1 and the second cylindrical body 211-2 are connected to each other. The inner diameter (or outer diameter) of the first cylindrical body 211-1 is larger than the inner diameter (or outer diameter) of the second cylindrical body 211-2. That is, the cylindrical member 210 has a structure in which the first cylindrical body 211-1 and the second cylindrical body 211-2 are connected to each other in a stepped manner. However, the structure of the cylindrical member 210 is not limited thereto. The cylindrical member 210 may have a structure in which the first cylindrical body 211-1 and the second cylindrical body 211-2 are connected to each other in a tapered manner.

The inner diameter of the second cylindrical body 211-2 is approximately equal to the outer diameter of the metal sheath 110, and the first end 111-1 of the metal sheath 110 is inserted into the second cylindrical body 211-2 of the cylindrical member 210. In other words, the second cylindrical body 211-2 of the cylindrical member 210 covers the first end 111-1 of the metal sheath 110. An opening portion of the cylindrical member 210 (an opening portion on the side of the first cylindrical body 211-1) is covered with the lid member 220. A flange portion 212 is disposed on the outer circumferential surface of the first cylindrical body 211-1, and the lid member 220 is engaged by an end of the first cylindrical body 211-1 and the flange portion 212.

The first end 111-1 of the metal sheath 110 inserted into the second cylindrical body 211-2 of the cylindrical member 210 is joined to the second cylindrical body 211-2 of the cylindrical member 210 by using welding, brazing, or the like. The lid member 220 is joined to the flange portion 212 by using welding, screwing, brazing, or the like. For example, an alloy containing silver, copper, and zinc, an alloy containing copper and zinc, copper containing a trace amount of phosphorus, an alloy containing aluminum, an alloy containing titanium, copper, and nickel, an alloy containing titanium, zirconium, and copper, or an alloy containing titanium, zirconium, copper, and nickel can be used as the brazing material.

The lid member 220 includes an opening portion 221. The diameter of the opening portion 221 of the lid member 220 is smaller than the diameter of the opening portion of the first cylinder 211-1 of the cylindrical member 210. The two lead wires 240 are inserted into the opening portion 221 of the lid member 220. That is, one end of the lead wire 240 is located inside the cylindrical member 210, and the other end of the lead wire 240 is located outside the cylindrical member 210. The connection terminal 250 is connected to the other end of the lead wire 240. The connection terminal 250 is connected to a power source that supplies power to the sheath heater 10.

The locking member 230 is attached to the lead wire 240 that extends to the outside of the cylindrical member 210 through the opening portion of the lid member 220. The locking member 230 clamps the lead wire 240 and is fixed to the lead wire 240. Although the locking member 230 may be in contact with the lid member 220, the locking member 230 and the lid member 220 are not joined to each other. For example, although the locking member 230 is a set collar, the locking member 230 is not limited thereto.

In the cylindrical member 210, the heater wire 120 is connected to the lead wire 240. Specifically, one end of the lead wires 240 is connected to each of both ends of the heater wire 120 via the crimp sleeve 260. Therefore, the two crimp sleeves 260 corresponding to the two lead wires 240 are in the cylindrical member 210.

The heater wire 120 may expand and contract due to heat generation, etc. In this case, if the lead wire 240 connected to the heater wire 120 is fixed, the heater wire 120 may lose its flexibility and may break. Therefore, as described above, the locking member 230 fixed to the lead wire 240 is not joined to the lid member 220 in the sheath heater 10, and is configured to move in accordance with the expansion and contraction of the heater wire 120.

The second insulating tube 270 and two third insulating tubes 280 are disposed in the cylindrical member 210. As shown in FIGS. 3B and 3C, although the cross-sectional shape of the second insulating tube 270 is substantially an ellipse having a straight portion, the cross-sectional shape of the second insulating tube 270 is not limited thereto. The maximum outer diameter of the second insulating tube 270 is substantially the same as the inner diameter of the first cylindrical body 211-1 of the cylindrical member 210. The second insulating tube 270 includes two second through holes 271. Each of the two crimp sleeves 260 is disposed in the second through hole 271. Therefore, the two crimp sleeves 260 are electrically insulated by a partition between the two second through holes 271 of the second insulating tube 270. The third insulating tube 280 is disposed between the first insulating tube 140 and the second insulating tube 270. Although the cross-sectional shape of the third insulating tube 280 is a circle, the cross-sectional shape of the third insulating tube 280 is not limited thereto. The third insulating tube 280 includes at least one third through hole 281. The heater wire 120 extending from the first through hole 141 of the first insulating tube 140 is inserted into the third through hole 281. The two heater wires 120 extend inside the cylindrical member 210. Each of the two heater wires 120 is covered with the third insulating tube 280 inside the cylindrical member 210 in order to prevent a short circuit of the two heater wires 120 extending between the first insulating tube 140 and the second insulating tube 270.

The outer diameter of the third insulating tube 280 is smaller than the hole diameter of the second through hole 271 of the second insulating tube 270. At least a portion of the third insulating tube 280 may be inserted into the second through hole 271 of the second insulating tube 270.

The same material of the metal sheath 110 can be used as the material of each of the cylindrical member 210 and the lid member 220. Further, the material of each of the cylindrical member 210 and the lid member 220 may further include stainless steel or the like.

The same material as that of the first insulating tube 140 can be used as each of the second insulating tube 270 and the third insulating tube 280.

As described above, the sheath heater 10 does not include any component with a low heat resistance temperature, such as an epoxy adhesive. Therefore, the heat resistance of the sheath heater 10 is improved.

The sheath heater 10 is a so-called one-terminal type sheath heater. However, the configuration of the sheath heater 10 can also be applied to a two-terminal type sheath heater, and similar effects can be achieved.

### <Second Embodiment>

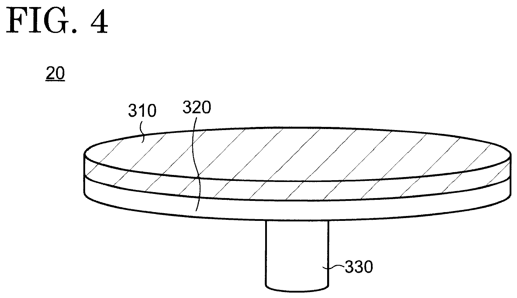

A stage 20 according to an embodiment of the present invention is described with reference to FIGS 4 to 6. The stage 20 includes the sheath heater 10. Therefore, a description of the same or similar configuration as that described in the First Embodiment may be omitted in the following description.

FIG. 4 is a schematic perspective view showing an external configuration of the stage 20 according to an embodiment of the present invention.

As shown in FIG. 4, the stage 20 includes a first support plate 310, a second support plate 320, and a shaft 330. The first support plate 310 and the second support plate 320 overlap each other, and the second support plate 320 is disposed below the first support plate 310. The second support plate 320 is joined to the first support plate 310 by welding, screwing, brazing, or the like. The shaft 330 is disposed below the second support plate 320 so as to support the first support plate 310 and the second support plate 320. The shaft 330 is joined to the second support plate 320 by welding, screwing, brazing, or the like.

A semiconductor substrate including silicon or a compound semiconductor, and an insulating substrate including quartz or glass is placed on the first support plate 310. Therefore, an upper surface of the first support plate 310 has a flat surface. For example, a metal having a thermal conductivity greater than or equal to 200 W/mK and less than or equal to 430 W/mK can be used as the material of the first support plate 310. When a metal having a high thermal conductivity is included in the first support plate 310, the thermal energy generated by the sheath heater 10 can be efficiently conducted to the first support plate 310. Further, the metal included in the first support plate 310 preferably has a thermal expansion coefficient greater than or equal to 5×10⁻⁶ /K and less than or equal to 25×10⁻⁶ /K. Specifically, titanium, aluminum, stainless steel, or the like can be used as the metal of the first support plate 310.

Although not shown in the figures, the first support plate 310 may be provided with an electrostatic chuck for fixing the substrate, a through hole for supplying a gas with high thermal conductivity such as helium between the substrate and the stage 20, or a circulation channel for circulating a liquid medium.

The same metal of the first support plate 310 can be used as the second support plate 320. The metal included in the second support plate 320 may be the same as or different from the metal included in the first support plate 310. When the metal included in the first support plate 310 and the metal included in the second support plate 320 are different from each other, it is preferable that the respective metals are selected so that the difference in thermal expansion coefficient is less than or equal to 10×10⁻⁶ /K. Since this suppresses deformation of the stage 20 due to the difference in thermal expansion, the reliability of the stage 20 can be improved.

Although not shown in the figures, a third support plate may be disposed below the second support plate 320 in the stage 20. The third support plate includes a similar configuration to the first support plate 310 or the second support plate 320. The third support plate may also be joined to the second support plate 320 by welding, screwing, brazing, or the like.

The shaft 330 has a hollow structure in order to store the lead wires 240 of the sheath heater 10. When the stage 20 is provided with an electrostatic chuck, wirings connected to the electrostatic chuck are also stored in the shaft 330.

Although not shown in the figures, the shaft 330 may be connected to a rotation mechanism. When the shaft 330 is connected to the rotation mechanism, the stage 20 can be rotated around the long axis of the shaft 330.

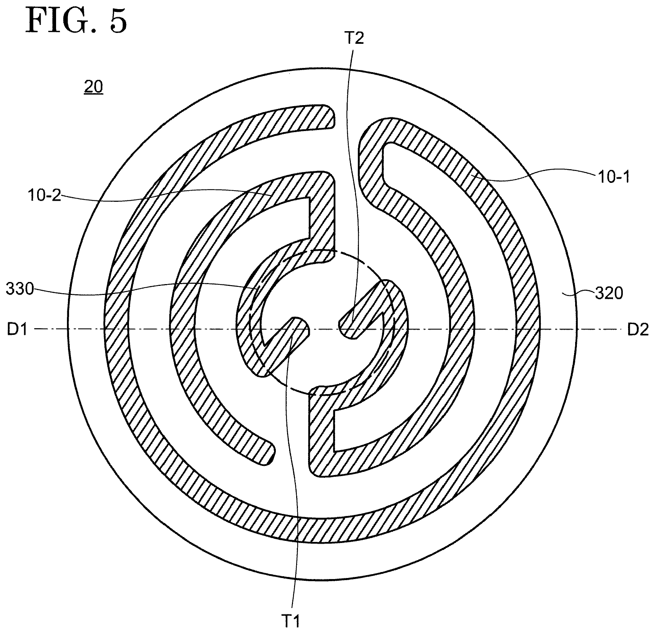

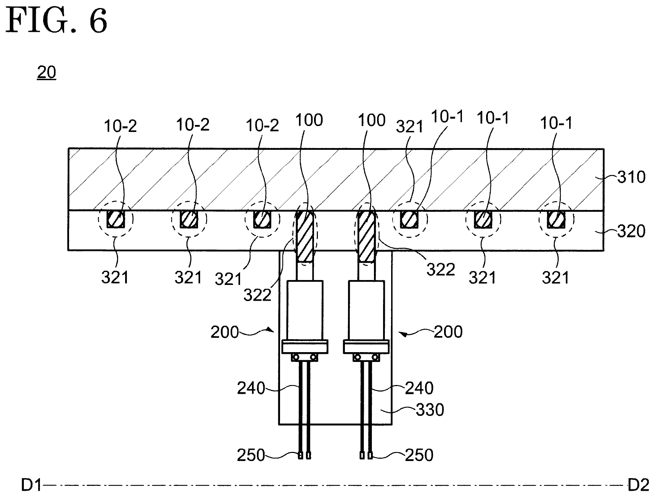

FIG. 5 is a schematic top view showing an arrangement of the sheath heater 10 included in the stage 20 according to an embodiment of the present invention. For convenience of explanation, the first support plate 310 is omitted in FIG. 5. Further, the shaft 330 is shown by a dotted line. FIG. 6 is a schematic cross-sectional view showing an internal configuration of the stage 20 according to an embodiment of the present invention. Specifically, FIG. 6 is a cross-sectional view of the stage 20 taken along the line D1-D2 shown in FIG. 5.

As shown in FIG. 5, the stage 20 includes a first sheath heater 10-1 and a second sheath heater 10-2. The first sheath heater 10-1 and the second sheath heater 10-2 are arranged on the second support plate 320. In the following description, when the first sheath heater 10-1 and the second sheath heater 10-2 are not specifically distinguished, the first sheath heater 10-1 and the second sheath heater 10-2 are referred to as the sheath heater 10.

As shown in FIG. 6, a groove 321 is provided on an upper surface of the second support plate 320. The depth of the groove 321 is approximately the same as the outer diameter of the sheath heater 10. Specifically, the depth of the groove 321 is greater than 100% and less than or equal to 150% of the outer diameter of the sheath heater 10, preferably greater than 100% and less than or equal to 120%, and particularly preferably greater than 100% and less than or equal to 110%. The first sheath heater 10-1 and the second sheath heater 10-2 are arranged so as to be embedded in the groove 321.

The second support plate 320 is provided with two through holes 322 in a region overlapping the shaft 330. In each of the first sheath heater 10-1 and the second sheath heater 10-2 arranged on the second support plate 320, the heater portion 100 is bent and inserted into the through hole 322, and the terminal portion 200 is stored in the shaft 330.

The connection terminal 250 of the terminal portion 200 is connected to a heater power supply (not shown in the figures). When power is supplied from the heater power supply to the heater portion 100 via the lead wire 240, the heater portion 100 generates heat, and the first support plate t and the second support plate 320 are heated.

As described above, the stage 20 includes the sheath heater 10 with improved heat resistance. Therefore, even when the stage 20 has a configuration in which the first end 111-1 of the sealed metal sheath 110 is stored inside the shaft 330, the stage 20 can be used at high temperatures. That is, when the sheath heater 10 is included in the stage 20, the operating temperature range of the stage 20 can be widened. Further, since the first sheath heater 10-1 and the second sheath heater 10-2 can be controlled independently, the temperature of the substrate placed on the stage 20 can be uniformly and precisely controlled.

### <Modification 1>

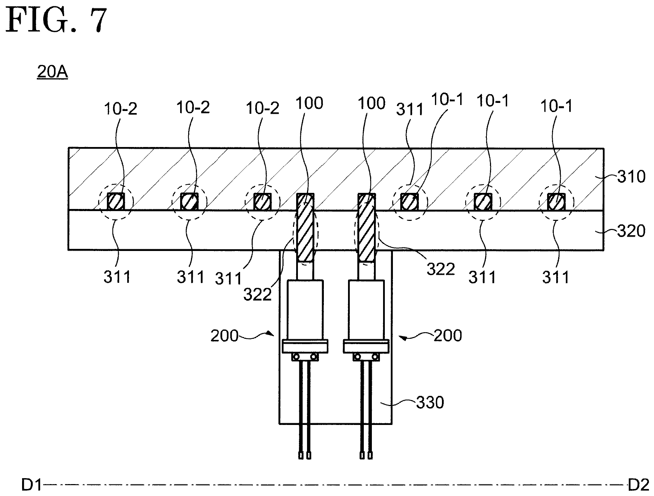

A stage 20A which is one modification of the stage 20 is described with reference to FIG. 7. In the following description, when a configuration of the stage 20A is similar to that of the stage 20, the description of the configuration of the stage 20A may be omitted.

FIG. 7 is a schematic cross-sectional view showing an internal configuration of the stage 20A according to an embodiment of the present invention. Specifically, FIG. 7 is a cross-sectional view of the stage 20A taken along line D1-D2 shown in FIG. 5.

As shown in FIG. 7, a groove 311 is provided on a lower surface of the first support plate 310. The depth of the groove 311 is approximately the same as the outer diameter of the sheath heater 10. Specifically, the depth of the groove 311 is greater than 100% and less than or equal to 150%, preferably greater than 100% and less than or equal to 120%, and particularly preferably greater than 100% and less than or equal to 110% of the outer diameter of the sheath heater 10. The first sheath heater 10-1 and the second sheath heater 10-2 are arranged so as to be embedded in the groove 311.

An end of the groove 311 of the first support plate 310 is provided in a region overlapping the shaft 330. The end of the groove 311 communicates with a through hole 322 of the second support plate 320. Therefore, in each of the first sheath heater 10-1 and the second sheath heater 10-2 arranged on the first support plate 310, the heater portion 100 is bent and inserted into the through hole 322, and the terminal portion 200 is stored in the shaft 330.

As described above, the stage 20A also includes the sheath heater 10 with improved heat resistance. Therefore, it is possible to widen the operating temperature range of the stage 20A. Further, since the first sheath heater 10-1 and the second sheath heater 10-2 can be controlled independently, the temperature of the substrate placed on the stage 20A can be controlled uniformly and precisely.

### <Modification 2>

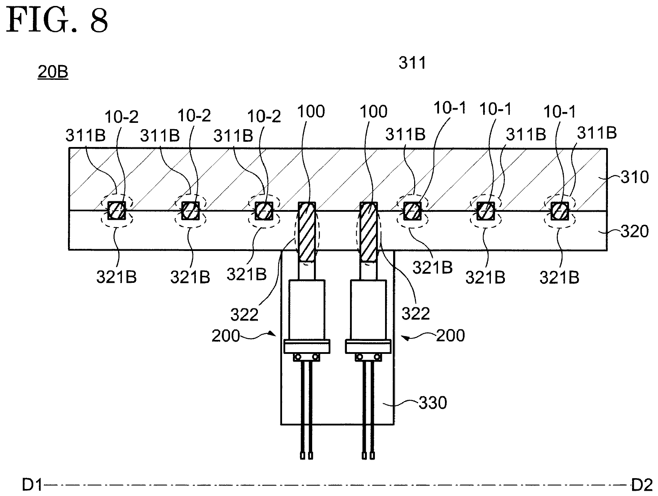

A stage 20B which is another modification of the stage 20 is described with reference to FIG. 8. In the following description, when a configuration of the stage 20B is similar to that of the stage 20, the description of the configuration of the stage 20B may be omitted.

FIG. 8 is a schematic cross-sectional view showing an internal configuration of the stage 20B according to an embodiment of the present invention. Specifically, FIG. 8 is a cross-sectional view of the stage 20B taken along line D1-D2 shown in FIG. 5.

As shown in FIG. 8, a groove 311B is provided on the lower surface of the first support plate 310. A groove 321B is provided on the upper surface of the second support plate 320. The position of the groove 311B corresponds to the position of the groove 321B. The depth of the groove 311B may be the same as or different from the depth of the groove 321B. However, the sum of the depth of the groove 311B and the depth of the groove 321B is approximately the same as the outer diameter of the sheath heater 10. Specifically, the sum of the depth of the groove 311B and the depth of the groove 321B is greater than 100% and less than or equal to 150%, preferably greater than 100% and less than or equal to 120%, and particularly preferably greater than 100% and less than or equal to 110% of the outer diameter of the sheath heater 10. The first sheath heater 10-1 and the second sheath heater 10-2 are arranged so as to be embedded in the groove 311B and the groove 321B.

A through hole 322 of the second support plate 320 is provided in a region overlapping the shaft 330. In each of the first sheath heater 10-1 and the second sheath heater 10-2 arranged between the first support plate 310 and the second support plate 320, the heater portion 100 is bent and inserted into the through hole 322, and the terminal portion 200 is stored in the shaft 330.

As described above, the stage 20B also includes the sheath heater 10 with improved heat resistance. Therefore, it is possible to widen the operating temperature range of the stage 20B. Further, since the first sheath heater 10-1 and the second sheath heater 10-2 can be controlled independently, the temperature of the substrate placed on the stage 20B can be controlled uniformly and precisely.

### <Modification 3>

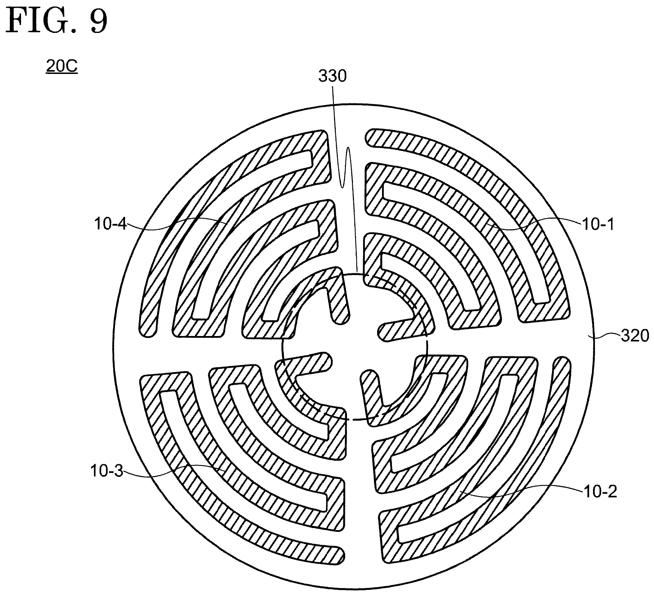

A stage 20C which is another modification of the stage 20 is described with reference to FIG. 9. In the following description, when a configuration of the stage 20C is similar to that of the stage 20, the description of the configuration of the stage 20C may be omitted.

FIG. 9 is a schematic top view showing an arrangement of sheath heaters included in the stage 20C according to an embodiment of the present invention. For convenience of explanation, the first support plate 310 is omitted in FIG. 9.

As shown in FIG. 9, the stage 20C includes a first sheath heater 10-1, a second sheath heater 10-2, a third sheath heater 10-3, and a fourth sheath heater 10-4. The first sheath heater 10-1 to the fourth sheath heater 10-4 are arranged on the second support plate 320.

In the stage 20C, the second support plate 320 is divided into four sections, and four independent sheath heaters 10 are arranged in each of the four sections. In each of the four sections, the sheath heaters 10 are arranged in a zigzag pattern to form an arc. The first sheath heater 10-1 to the fourth sheath heater 10-4 have the same arrangement configuration. Further, when one of the first sheath heater 10-1 to the fourth sheath heater 10-4 is rotated 90 degrees about an axis passing through the center of the second support plate 320, it is arranged so as to overlap the other of the first sheath heater 10-1 to the fourth sheath heater 10-4.

As described above, the stage 20C also includes the sheath heater 10 with improved heat resistance. Therefore, it is possible to widen the operating temperature range of the stage 20C. Further, since the first sheath heater 10-1 to the fourth sheath heater 10-4 can be controlled independently, the temperature of the substrate placed on the stage 20B can be controlled uniformly and precisely for each section.

### <Third Embodiment>

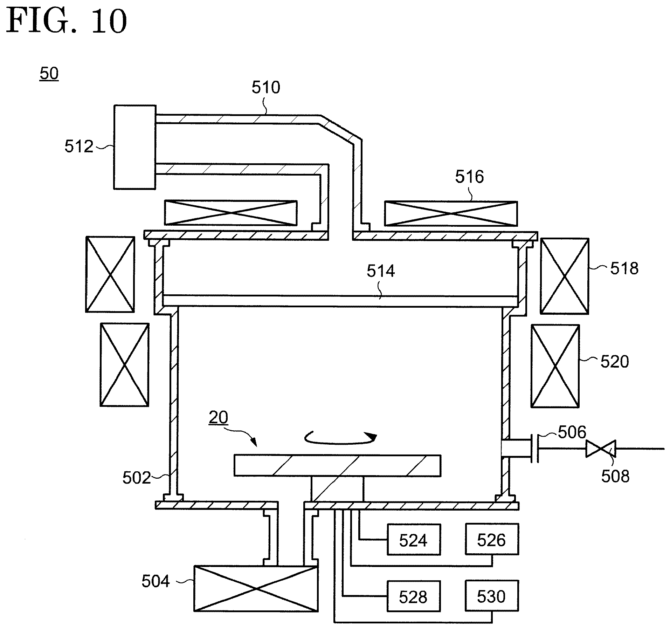

An etching apparatus 50 according to an embodiment of the present invention is described with reference to FIG. 10. The etching apparatus 50 includes a stage 20. Therefore, a description of the same or similar configuration as that described in the Second Embodiment may be omitted in the following description.

FIG. 10 is a schematic cross-sectional view showing a configuration of the etching apparatus 50 according to an embodiment of the present invention.

The etching apparatus 50 can perform dry etching on various films. The etching apparatus 50 includes a chamber 502. The chamber 502 supplies a space to perform etching on a film of a conductor, an insulator, or a semiconductor formed on a substrate.

An exhaust device 504 is connected to the chamber 502, by which the inside of the chamber 502 can be set under a reduced-pressure atmosphere. The chamber 502 is further provided with an inlet tube 506 for introducing a reaction gas which is supplied to the chamber 502 through a valve 508. For example, a fluorine-containing organic compound such as tetrafluorocarbon (CF₄), octafluorocyclobutane (*c*-C₄F₈), decafluorocyclopentane (*c*-C₅F₁₀), hexafluorobutadiene (C₄F₆) is used as the reaction gas.

A microwave source 512 may be provided at an upper portion of the chamber 502 through a waveguide tube 510. The microwave source 512 has an antenna and the like for supplying a microwave and outputs a high-frequency microwave such as a microwave of 2.45 GHz and a radio wave (RF) of 13.56 MHz. The microwave generated by the microwave source 512 is transmitted to the upper portion of the chamber 502 with the waveguide tube 510 and then introduced into the chamber 502 through a window 514 including quartz, ceramic, or the like. The reaction gas is plasmatized with the microwave, and the etching proceeds with electrons, ions, and radicals included in the plasma.

The stage 20 for placing a substrate is provided at a lower portion of the chamber 502. A power source 524 is connected to the stage 20, and high-frequency electric power is supplied to the stage 20, thereby forming an electric field in a direction perpendicular to the surfaces of the stage 20 and the substrate with the microwave. Magnets 516, 518, and 520 may be provided at the upper portion and on a side surface of the chamber 502. The magnets 516, 518, and 520 may each be a permanent magnet or an electromagnet having an electromagnetic coil. A magnetic component parallel to the surfaces of the stage 20 and the substrate is generated with the magnets 516, 518, and 520. The electrons in the plasma resonate upon receiving a Lorentz force in association with the electrical field generated by the microwave and are bound on the surfaces of the stage 20 and the substrate. Accordingly, high-density plasma can be generated on the substrate surface.

A heater power source 530 for controlling the sheath heater 10 provided to the stage 20 is connected to the stage 20. As an optional structure, a power source 526 for an electrostatic chuck for fixing the substrate to the stage, a temperature controller 528 for controlling the temperature of a medium circulated in the stage 20, and a rotation-controlling device (not shown in the figures) for rotating the stage 20 may be further connected to the stage 20.

### <Fourth Embodiment>

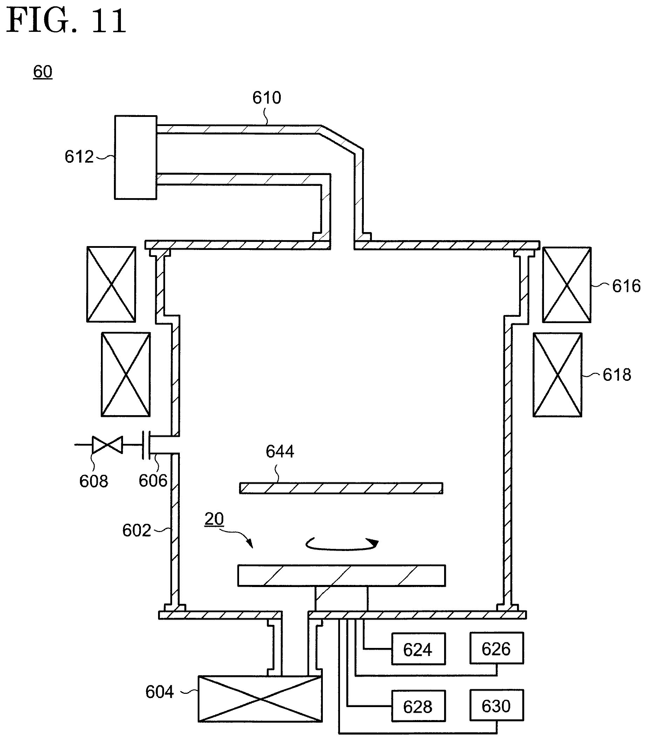

A CVD apparatus 60 according to an embodiment of the present invention is described with reference to FIG. 11. The CVD apparatus 60 includes the stage 20. Therefore, a description of the same or similar configuration as that described in the Second Embodiment may be omitted in the following description.

FIG. 11 is a schematic cross-sectional view showing a configuration of the CVD apparatus 60 according to an embodiment of the present invention.

The CVD apparatus 60 includes a chamber 602. The CVD apparatus 60 provides a space for chemically reacting a reaction gas to form various films on a substrate.

An exhaust apparatus 604 is connected to the chamber 602, by which the pressure in the chamber 602 can be reduced. The chamber 602 is further provided with an inlet tube 606 for introducing the reaction gas, and the reaction gas for film formation is introduced into the chamber 602 through a valve 608. As the reaction gas, a variety of gases can be used depending on the films to be formed. The gas may be a liquid at a normal temperature. For example, thin films of silicon, silicon oxide, silicon nitride, and the like can be prepared using silane, dichlorosilane, tetraethoxysilane, and the like. Further, metal films of tungsten, aluminum, and the like can be prepared using tungsten fluoride, trimethylaluminum, and the like.

Similar to the etching apparatus 50, a microwave source 612 may be provided at an upper portion of the chamber 602 through a waveguide tube 610. A microwave generated with the microwave source 612 is introduced into the chamber 602 with the waveguide tube 610. The reaction gas is plasmatized with the microwave, and the chemical reaction of the gas is promoted by a variety of active species included in the plasma. Products obtained by the chemical reactions are deposited over a substrate, resulting in a thin film. As an optional element, a magnet 644 may be provided in the chamber 602 in order to increase plasma density. The stage 20 is disposed at a lower portion of the chamber 302, which enables deposition of a thin film in a state where a substrate is placed over the stage 20. Similar to the etching apparatus 50, magnets 616 and 618 may be further provided on a side surface of the chamber 602.

A heater power source 630 for controlling the sheath heater 10 provided in the stage 20 is further connected to the stage 20. As an optional element, a power source 624 for supplying a high-frequency electric power to the stage 20, a power source 626 for an electrostatic chuck, a temperature controller 628 for temperature control of a medium circulated in the stage 20, or a rotation-controlling device (not shown in the figures) for rotating the stage 20, and the like may be connected to the stage 20.

### <Fifth Embodiment>

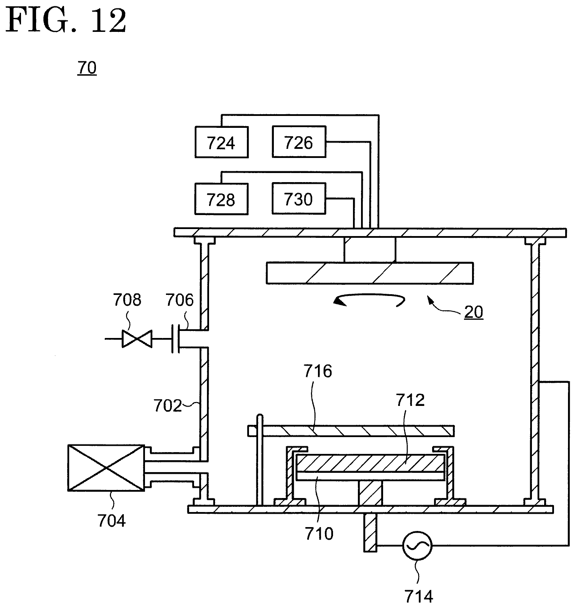

A sputtering apparatus 70 according to an embodiment of the present invention is described with reference to FIG. 12. The sputtering apparatus 70 includes a stage 20. Therefore, a description of the same or similar configuration as that described in the Second Embodiment may be omitted in the following description.

FIG. 12 is a schematic cross-sectional view showing a configuration of the sputtering apparatus 70 according to an embodiment of the present invention.

The sputtering apparatus 70 includes a chamber 702. The sputtering apparatus 70 provides a space for collision of high-speed ions with a target and deposition of target atoms generated by the collision.

An exhaust apparatus 704 for reducing pressure in the chamber 702 is connected to the chamber 702. An inlet tube 706 for supplying a sputtering gas such as argon into the chamber 702 and a valve 708 are provided to the chamber 702.

A target stage 710 for supporting a target containing a material to be deposited and functioning as a cathode is arranged at a lower portion of the chamber 702, over which the target 712 is provided. A high-frequency power source 714 is connected to the target stage 710, and plasma can be generated in the chamber 702 with the high-frequency power source 714.

The stage 20 may be disposed at an upper portion of the chamber 702. In this case, film-formation proceeds in the state where a substrate is placed under the stage 20. Similar to the etching apparatus 50 and the CVD apparatus 60, a heater-power source 730 is connected to the stage 20. A power source 724 for supplying a high-frequency electric power to the stage 20, a power source 726 for an electrostatic chuck, a temperature controller 728, and a rotation-controlling device (not shown in the figures) for rotating the stage 20 may be connected to the stage 20.

Argon ions accelerated with the plasma generated in the chamber 702 collide with the target 712, and the atoms of the target 712 are sputtered. The sputtered atoms fly to a substrate placed under the stage 20 while a shutter 716 is opened and are deposited.

In the present embodiment, the configuration is exemplified in which the stage 20 and the target stage 710 are respectively disposed at the upper portion and the lower portion of the chamber 702. However, the present embodiment is not limited to this configuration, and the sputtering apparatus 70 may be configured so that the target 712 is positioned over the stage 20. Alternatively, the stage 20 may be disposed so that a main surface of the substrate is arranged perpendicular to the horizontal plane, and the target stage 710 may be arranged to oppose the stage 20.

### <Sixth Embodiment>

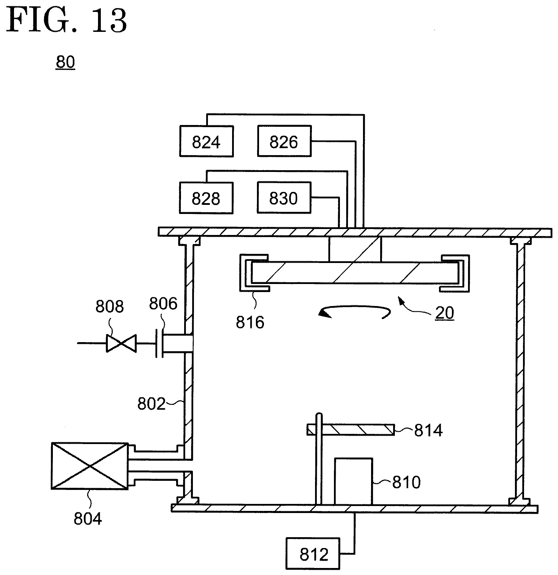

An evaporation apparatus 80 according to an embodiment of the present invention is described with reference to FIG. 13. The evaporation apparatus 80 includes the stage 20. Therefore, a description of the same or similar configuration as that described in the Second Embodiment may be omitted in the following description.

FIG. 13 is a schematic cross-sectional view showing a configuration of the evaporation apparatus 80 according to an embodiment of the present invention.

The evaporation apparatus 80 includes a chamber 802. The chamber 802 provides a space for evaporating a material in an evaporation source 810 and depositing the evaporated material over a substrate.

An exhaust apparatus 804 for making the inside of the chamber 802 a high vacuum is connected to the chamber 802. An inlet tube 806 for returning the inside of the chamber 802 to an atmospheric pressure is provided to the chamber 802, and an inert gas such as nitrogen and argon is introduced into the chamber 802 through a valve 808.

The stage 20 may be disposed at an upper portion of the chamber 802. Deposition of the material proceeds in a state where a substrate is placed under the stage 20. Similar to the etching apparatus 50, the CVD apparatus 60, and the sputtering apparatus 70, a heater-power source 828 is connected to the stage 20. As an optional structure, a power source 824 for an electrostatic chuck, a temperature controller 826, and a rotation-controlling device 830 for rotating the stage 20 may be connected to the stage 20. The stage 20 may further include a mask holder 816 for fixing a metal mask between the substrate and the evaporation source 610. With this structure, it is possible to arrange the metal mask at a vicinity of the substrate so that an opening portion of the metal mask overlaps a region where the material is to be deposited.

The evaporation source 810 is provided at a lower portion of the chamber into which the material subjected to evaporation is charged. A heater for heating the material is provided to the evaporation source 810, and the heater is controlled with a controlling apparatus 812. The inside of the chamber 802 is made a high vacuum using the exhaust apparatus 804, and the material is vaporized by heating the evaporation source 810 to start evaporation. A shutter 814 is opened when an evaporation rate becomes constant, by which deposition of the material is started over the substrate.

The stage 20 is used in the etching apparatus 50, the CVD apparatus 60, the sputtering apparatus 70, and the evaporation apparatus 80 described in the Third to Sixth Embodiments. When the stage 20 is used, it is possible to uniformly heat the substrate and to precisely control the heating temperature. Therefore, when the etching apparatus 50, the CVD apparatus 60, the sputtering apparatus 70, or the evaporation apparatus 80 is used, it is possible to uniformly form various films with controlled characteristics over the substrate. Further, since the first end 111-1 of the metal sheath 110 is stored in the shaft 330 in the stage 20, the degree of freedom in the position where the stage 20 is disposed is improved.

Each of the embodiments described above as the embodiments of the present invention can be appropriately combined and implemented as long as no contradiction is caused..

Further, it is understood that, even if the effect is different from those provided by each of the above-described embodiments, the effect obvious from the description in the specification or easily predicted by persons ordinarily skilled in the art is apparently derived from the present invention.

### REFERENCES SIGN LIST

10: sheath heater, 20, 20A, 20B, 20C: stage, 50: etching apparatus, 60: CVD apparatus, 70: sputtering apparatus, 80: evaporation apparatus, 100: heater portion, 110: metal sheath, 111: end, 120: heater wire, 130: insulating material, 140: first insulating tube, 141: first throgu hole, 150: sealing material, 200: terminal portion, 210: cylindrical member, 211: cylindrical body, 212: flange portion, 220: lid member, 221: opening portion, 230: locking member, 240: lead wire, 250: connection terminal, 260: crimp sleeve, 270: second insulating tube, 271: second through hole, 280: third insulating tube, 281: third through hole, 310: first support plate, 311, 311B: groove, 320: second support plate, 321, 321B: groove, 322: through hole, 330: shaft, 502: chamber, 504: exhaust device, 506: inlet tube, 508: valve, 510: waveguide tube, 512: microwave source, 514: window, 516: magnet, 518: magnet, 520: magnet, 524: power source, 526:power source, 528: temperature controller, 530: heater power source, 602: chamber, 604: exhaust device, 606: inlet tube, 608: valve, 610: waveguide tube, 612: microwave source, 616: magnet, 618: magnet, 624: power source, 626: power source, 628: temperature controller, 630: heater power source, 644: magnet, 702: chamber, 704: exhaust device, 706: inlet tube, 708: valve, 710: target stage, 712: target, 714: high-frequency power source, 716: shutter, 724: power source, 726: power source, 728: temperature controller, 730: heater power source, 802: chamber, 804: exhaust device, 806: inlet tube, 808: valve, 810: evaporation source, 812: controlling apparatus, 814: shutter, 816: mask holder, 824: power source, 826: temperature controller, 828: heater power source, 830: rotation-controlling device.

## Claims

1. A sheath heater (10), comprising:
a metal sheath (110);
a heater wire (120) disposed in the metal sheath (110);
an insulating material (130) filled in the metal sheath (110) so as to separate the metal sheath (110) and the heater wire (120);
a lead wire (240) for supplying power to the heater wire (120);
a crimp sleeve (260) connecting the heater wire (120) extending from an end of the metal sheath (110) with the lead wire (240);
a cylindrical member (210) covering the end of the metal sheath (110); and
a lid member (220) engaging with the cylindrical member (210) and including an opening into which the lead wire (240) is inserted,
**characterised in that**
the crimp sleeve (260) is disposed in the cylindrical member (210),
wherein the end of the metal sheath (110) comprises:
a first insulating tube (140) comprising a first through hole (141) into which the heater wire (120) is inserted; and
a sealing material (150) filling a gap between the metal sheath (110) and the first insulating tube (140), and
wherein the sealing material (150) comprises a ceramic binder.

2. The sheath heater (10) according to claim 1, wherein the first insulating tube (140) comprises the two first through holes (141).

3. The sheath heater (10) according to claim 1, futher comprising a second insulating tube (270) disposed in the cylindrical member (210) and comprising a second through hole (271),
wherein the crimp sleeve (260) is disposed in the second through hole (271).

4. The sheath heater (10) according to claim 3, wherein the second insulating tube (270) comprises the two second through holes (271).

5. The sheath heater (10) according to claim 3, further comprisng a locking member (230) fixed to the lead wire (240),
wherein the locking member (230) is not joined to the lid member (220).

6. The sheath heater (10) according to claim 5, wherein the locking member (230) is fixed to the lead wire (240) by clamping the lead wire (240).

7. The sheath heater (10) according to claim 3, further comprising a third insulating tube (280) disposed between the first insulating tube (140) and the second insulating tube (270) in the cylindrical member (210) and comprising a third through hole (281) into which the heater wire (120) is inserted.

8. The sheath heater (10) according to claim 7, wherein an outer diameter of the third insulating tube (280) is smaller than a hole diameter of the second through hole (271).

9. The sheath heater (10) according to claim 7, wherein a part of the third insulating tube (280) is inserted into the second through hole (271).

10. The sheath heater (10) according to claim 7, wherein the two third insulating tubes (280) are disposed in the cylindrical member (210).

11. A stage (20, 20A, 20B, 20C), comprising:
a shaft (330); and
the sheath heater (10) according to any one of claims 1 to 10,
wherein the end of the metal sheath (110) is stored in the shaft (330).

## Patentansprüche

1. Mantelheizer (10), umfassend:
eine Metallummantelung (110);
einen Heizdraht (120), der sich in der Metallummantelung (110) befindet;
ein isolierendes Material (130), das so in die Metallummantelung (110) eingefüllt ist, dass es die Metallummantelung (110) und den Heizdraht (120) voneinander trennt;
einen Anschlussdraht (240) zur Stromversorgung des Heizdrahts (120);
eine Quetschhülse (260), die den Heizdraht (120), der sich von einem Ende der Metallummantelung (110) aus erstreckt, mit dem Anschlussdraht (240) verbindet;
ein zylindrisches Element (210), das das Ende der Metallummantelung (110) bedeckt; und
ein Deckelelement (220), das mit dem zylindrischen Element (210) in Eingriff steht und eine Öffnung umfasst, in die der Anschlussdraht (240) eingesteckt ist,
**dadurch gekennzeichnet, dass** sich die Quetschhülse (260) in dem zylindrischen Element (210) befindet,
wobei das Ende der Metallummantelung (110) Folgendes umfasst:
ein erstes isolierendes Rohr (140), das eine erste Durchgangsbohrung (141) umfasst, in die der Heizdraht (120) eingesteckt ist; und
ein Dichtungsmaterial (150), das einen Spalt zwischen der Metallummantelung (110) und dem ersten isolierenden Rohr (140) füllt,
wobei das Dichtungsmaterial (150) ein keramisches Bindemittel umfasst.

2. Mantelheizer (10) gemäß Anspruch 1, wobei das erste isolierende Rohr (140) die zwei ersten Durchgangsbohrungen (141) umfasst.

3. Mantelheizer (10) gemäß Anspruch 1, weiterhin umfassend ein zweites isolierendes Rohr (270), das sich in dem zylindrischen Element (210) befindet und eine zweite Durchgangsbohrung (271) umfasst,
wobei sich die Quetschhülse (260) in der zweiten Durchgangsbohrung (271) befindet.

4. Mantelheizer (10) gemäß Anspruch 3, wobei das zweite isolierende Rohr (270) die zwei zweiten Durchgangsbohrungen (271) umfasst.

5. Mantelheizer (10) gemäß Anspruch 3, weiterhin umfassend ein Verriegelungselement (230), das an dem Anschlussdraht (240) befestigt ist,
wobei das Verriegelungselement (230) nicht mit dem Deckelelement (220) verbunden ist.

6. Mantelheizer (10) gemäß Anspruch 5, wobei das Verriegelungselement (230) durch Klemmen des Anschlussdrahts (240) an dem Anschlussdraht (240) befestigt ist.

7. Mantelheizer (10) gemäß Anspruch 3, weiterhin umfassend ein drittes isolierendes Rohr (280), das sich zwischen dem ersten isolierenden Rohr (140) und dem zweiten isolierenden Rohr (270) in dem zylindrischen Element (210) befindet und eine dritte Durchgangsbohrung (281) umfasst, in die der Heizdraht (120) eingesteckt ist.

8. Mantelheizer (10) gemäß Anspruch 7, wobei der Außendurchmesser des dritten isolierenden Rohrs (280) kleiner ist als der Lochdurchmesser der zweiten Durchgangsbohrung (271).

9. Mantelheizer (10) gemäß Anspruch 7, wobei ein Teil des dritten isolierenden Rohrs (280) in die zweite Durchgangsbohrung (271) eingesteckt ist.

10. Mantelheizer (10) gemäß Anspruch 7, wobei sich die zwei dritten isolierenden Rohre (280) in dem zylindrischen Element (210) befinden.

11. Tisch (20, 20A, 20B, 20C), umfassend:
einen Schaft (330); und
den Mantelheizer (10) gemäß einem der Ansprüche 1 bis 10,
wobei das Ende der Metallummantelung (110) in dem Schaft (330) untergebracht ist.

## Revendications

1. Réchauffeur blindé (10), comprenant :
une gaine métallique (110) ;
un fil chauffant (120) disposé dans la gaine métallique (110) ;
un matériau isolant (130) garnissant la gaine métallique (110) de manière à séparer la gaine métallique (110) et le fil chauffant (120) ;
un fil de raccordement (240) destiné à fournir de l'énergie au fil chauffant (120) ;
un manchon de sertissage (260) reliant le fil chauffant (120), qui s'étend depuis une extrémité de la gaine métallique (110), au fil de raccordement (240) ;
un élément cylindrique (210) recouvrant l'extrémité de la gaine métallique (110) ; et
un élément de couvercle (220) en prise avec l'élément cylindrique (210) et comprenant une ouverture dans laquelle le fil de raccordement (240) est inséré,
**caractérisé en ce que** ledit manchon de sertissage (260) est disposé dans l'élément cylindrique (210),
dans lequel l'extrémité de la gaine métallique (110) comprend :
un premier tube isolant (140) comprenant un premier trou traversant (141) dans lequel le fil chauffant (120) est inséré ; et
un matériau d'étanchéité (150) remplissant un espace entre la gaine métallique (110) et le premier tube isolant (140), et
dans lequel le matériau d'étanchéité (150) comprend un liant céramique.

2. Réchauffeur blindé (10) selon la revendication 1, dans lequel le premier tube isolant (140) comprend les deux premiers trous traversants (141).

3. Réchauffeur blindé (10) selon la revendication 1, comprenant en outre un deuxième tube isolant (270) disposé dans l'élément cylindrique (210) et comprenant un deuxième trou traversant (271),
dans lequel ledit manchon de sertissage (260) est disposé dans le deuxième trou traversant (271).

4. Réchauffeur blindé (10) selon la revendication 3, dans lequel le deuxième tube isolant (270) comprend les deux deuxièmes trous traversants (271).

5. Réchauffeur blindé (10) selon la revendication 3, comprenant en outre un élément de verrouillage (230) fixé au fil de raccordement (240),
dans lequel ledit élément de verrouillage (230) n'est pas relié à l'élément de couvercle (220).

6. Réchauffeur blindé (10) selon la revendication 5, dans lequel ledit élément de verrouillage (230) est fixé au fil de raccordement (240) par serrage du fil de raccordement (240).

7. Réchauffeur blindé (10) selon la revendication 3, comprenant en outre un troisième tube isolant (280) disposé entre le premier tube isolant (140) et le deuxième tube isolant (270) dans l'élément cylindrique (210), et comprenant un troisième trou traversant (281) dans lequel est inséré le fil chauffant (120).

8. Réchauffeur blindé (10) selon la revendication 7, dans lequel le diamètre extérieur du troisième tube isolant (280) est inférieur au diamètre du deuxième trou traversant (271).

9. Réchauffeur blindé (10) selon la revendication 7, dans lequel une partie du troisième tube isolant (280) est insérée dans le deuxième trou traversant (271).

10. Réchauffeur blindé (10) selon la revendication 7, dans lequel les deux troisièmes tubes isolants (280) sont disposés dans l'élément cylindrique (210).

11. Platine (20, 20A, 20B, 20C), comprenant :
une tige (330) ; et
le réchauffeur blindé (10) selon l'une quelconque des revendications 1 à 10,
dans lequel l'extrémité de la gaine métallique (110) est logée dans la tige (330).
